# FASCICULE DE BREVET EUROPEEN

(11) **EP 3 839 624 B1**
(45) Date de publication et mention de la délivrance du brevet: **13.09.2023**
(21) Numéro de dépôt: 19217372.2
(22) Date de dépôt: 18.12.2019
(51) Int. Cl.: G03F 7/00, G04B 19/12, B81C 99/00, C25D 5/02, C25D 1/00, G04B 13/02, G04B 15/14, G04B 19/06

(54) **PROCEDE DE FABRICATION D'UN COMPOSANT HORLOGER**
VERFAHREN ZUR HERSTELLUNG EINER UHRKOMPONENTE
METHOD FOR MANUFACTURING A TIMEPIECE COMPONENT

(43) Date de publication de la demande: 23.06.2021
(73) Titulaire: Nivarox-FAR S.A., 2400 Le Locle (CH)
(72) Inventeur: CUSIN, Pierre, 1423 Villars-Burquin (CH); GANDELHMAN, Alex, 2013 Colombier (CH); MUSY, Michel, 2552 Orpund (CH); GOLFIER, Clare, 2520 La Neuveville (CH)
(74) Mandataire: ICB SA

(56) Documents cités:
- EP-A1- 3 266 905
- WO-A1-2013/182615
- JP-A- 2006 161 138
- US-A1- 2006 261 518
- BACHER W ET AL: "THE LIGA TECHNIQUE AND ITS POTENTIAL FOR MICROSYSTEMS - A SURVEY", IEEE TRANSACTIONS ON INDUSTRIAL ELECTRONICS, IEEE SERVICE CENTER, PISCATAWAY, NJ, USA, PAGE(S) 431 - 441, XP000542368, ISSN: 0278-0046 * page 434 - page 436 *

## Description

### Domaine de l'invention

La présente invention concerne un procédé de fabrication d'une structure métallique complexe multi-niveaux au moyen de la technologie LIGA. L'invention concerne également une telle structure métallique, notamment des composants horlogers, obtenus par ce procédé.

### Arrière-plan de l'invention

On connaît déjà des procédés correspondant à la définition ci-dessus. En particulier, l'article d'A. B. Frazier et al. intitulé « Metallic Microstuctures Fabricated Using Photosensitive Polyimide Electroplating molds » et publié dans le journal of Microelectromechanical systems (Vol. 2, N deg. 2, June 1993) décrit un procédé pour la fabrication de structures métalliques multi-niveaux par croissance galvanique dans des moules de polyimide réalisés par photolithographie de couches de résine photosensible. Ce procédé comprend les étapes suivantes :
- créer sur un substrat une couche métallique sacrificielle et une couche d'amorçage pour une étape ultérieure de croissance galvanique,
- étaler une couche de polyimide photosensible,
- irradier la couche de polyimide avec un rayonnement UV à travers un masque correspondant au contour d'un niveau de la structure à obtenir,
- développer la couche de polyimide en dissolvant les parties non irradiées de façon à obtenir un moule en polyimide,
- remplir le moule de nickel jusqu'à la hauteur de celui-ci par croissance galvanique, et obtenir une surface supérieure sensiblement plane,
- déposer une fine couche de chrome sur toute la surface supérieure par vaporisation sous vide,
- déposer sur la couche de chrome une nouvelle couche de résine photosensible,
- irradier la couche de résine à travers un nouveau masque correspondant au contour du niveau suivant de la structure à obtenir,
- développer la couche de polyimide de façon à obtenir un nouveau moule,
- remplir le nouveau moule de nickel jusqu'à la hauteur de celui-ci par croissance galvanique,
- séparer la structure multi-niveaux et le moule en polyimide de la couche sacrificielle et du substrat,
- séparer la structure multi-niveaux du moule en polyimide.

On comprendra que le procédé qui vient d'être décrit peut, en principe, être mis en oeuvre de manière itérative pour obtenir des structures métalliques ayant plus de deux niveaux.

Le document de brevet WO2010/020515A1 décrit la fabrication d'une pièce à plusieurs niveaux en réalisant un moule de photoresist complet correspondant à la pièce finale à obtenir avant l'étape de dépôt galvanique du métal de la pièce dans le moule. Seules des pièces multi-niveaux dont les projections des niveaux sont incluses l'une dans l'autre sont réalisables par cette méthode.

On connait également du document de brevet EP2405301A1, un moule en photoresist comprenant au moins deux niveaux, les niveaux formés dans le substrat ne comportant que des flancs verticaux et lisses.

Ces procédés ne permettent que la fabrication de pièces dont leurs géométries de base sont cylindriques, et ne permettent pas la fabrication de pièces comprenant des géométries complexes telles que des anglages ou des chanfreins.

La demande de brevet JP 2006 161138 A décrit la fabrication d'une pièce à plusieurs niveaux en réalisant un moule en photoréserve correspondant à la pièce finale à obtenir avant l'étape de dépôt galvanique du métal de la pièce dans le moule en photoréserve. Ce moule en photoréserve est formé à l'aide d'un tampon d'emboutissage multi-niveaux. U

L'article de W. Bâcher et al. intitulé « The LIGA Technique and Its Potential for Microsystems - A Survey» et publié dans le journal IEEE Transactions on Industrial Electronics (VOL. 42, No. 5, 1995) décrit un procédé de fabrication de microstructures multi-niveaux combinant la lithographie aux rayons X et l'électroformage, ces microstructures pouvant présenter des parois latérales verticales et inclinées, ainsi que des structures étagées à géométrie variable. Un insert de moule métallique est utilisé pour modeler la surface supérieure d'une couche de réserve dans un procédé de moulage par injection. Puis la surface inférieure de la couche de réserve est structurée par lithographie à rayons X. La réserve à deux niveaux obtenue est ensuite utilisée pour fabriquer par électroformage un insert de moule qui peut être utilisé pour le moulage de microstructures multi-niveaux. U

### Résumé de l'invention

La présente invention a pour but de remédier aux inconvénients susmentionnés ainsi qu'à d'autres encore en fournissant un procédé permettant de fabriquer des composants horlogers métalliques multi-niveaux, en combinant une étape d'emboutissage à chaud à la technologie LIGA, dans lequel une couche conductrice est associée à une couche de résine pour chaque niveau pour permettre une croissance galvanique fiable dans le cas de composants multiniveaux.

La présente invention a également pour but de permettre la fabrication de pièces horlogères présentant des géométries complexes d'ordinaire infaisables via la technologie LIGA.

A cet effet l'invention a pour objet un procédé de fabrication d'un composant horloger comprenant les étapes suivantes :
a) se munir d'un substrat transparent, déposer une couche électriquement conductrice transparente sur la face avant du substrat, et y appliquer une couche de résine photosensible, le substrat comprenant des zones métallisées sur l'une de ses faces pour former un masque ;
b) effectuer un emboutissage à chaud via un tampon de la couche de résine photosensible, en pressant le tampon jusqu'à une distance prédéfinie du substrat de manière à conserver une couche de résine photosensible, pour mettre en forme la couche de résine photosensible et former au moins un premier niveau du composant horloger ;
c) irradier par la face arrière du substrat la couche de résine photosensible mise en forme à travers le masque définissant un deuxième niveau du composant et dissoudre les zones non irradiées de la couche de résine photosensible pour faire apparaître par endroit la couche électriquement conductrice transparente et former un moule comprenant un premier et un second niveau ;
d) déposer une couche métallique par électroformage dans le moule à partir de la couche électriquement conductrice transparente pour former le composant, la couche métallique atteignant la surface supérieure de la couche de résine photosensible ;
e) éliminer successivement le substrat, la couche électriquement conductrice transparente et la résine photosensible pour libérer le composant.

Ce procédé permet donc la réalisation de pièces multiniveaux.

Conformément à d'autres variantes avantageuses de l'invention :
- l'étape b) est réalisée sous vide ;
- lors de l'étape b), la couche de résine est chauffée entre 70°C et 150°C ;
- le tampon présente une empreinte en relief, au moins une partie de l'empreinte étant agencée pour être pressée à proximité de la surface du substrat lors de l'étape b) ;
- ladite empreinte du tampon définit ledit au moins un premier niveau du composant ;
- le procédé comprend une étape optionnelle entre l'étape c) et d) qui consiste à déposer localement une deuxième couche électriquement conductrice sur les zones irradiées de la couche de résine ;
- la deuxième couche électriquement conductrice est déposée à travers un masque chablon ;
- la deuxième couche électriquement conductrice est déposée via l'impression d'une encre ou une résine conductrice ;
- ladite couche électriquement conductrice transparente est du type Au, Ti, Pt, Ag
   Cr, Pd ou un empilement d'au moins deux de ces matériaux ;
- le substrat est en silicium ;
- la couche électriquement conductrice transparente présente une épaisseur comprise entre 50nm et 500nm.

Enfin, l'invention se rapporte à un composant horloger, obtenu selon un procédé conforme à l'invention, tel qu'une ancre ou une roue d'échappement par exemple.

On comprend donc que le procédé de l'invention trouve une application particulièrement avantageuse pour la fabrication de composants pour les pièces d'horlogerie.

### Description sommaire des dessins

D'autres caractéristiques et avantages de la présente invention ressortiront plus clairement de la description détaillée qui suit d'un exemple de réalisation d'un procédé selon l'invention, cet exemple étant donné seulement à titre purement illustratif et non limitatif, en liaison avec le dessin annexé sur lequel :

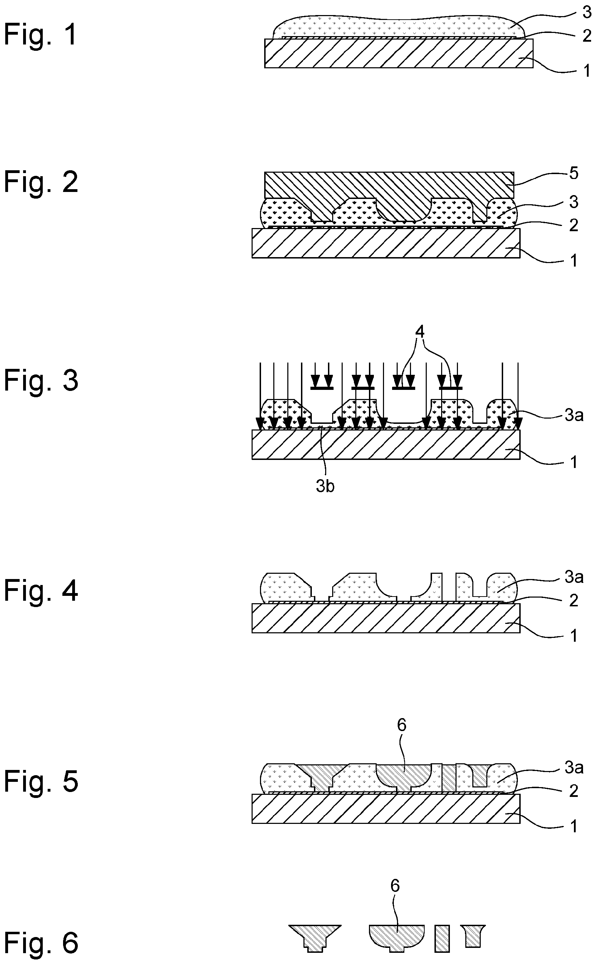

- les figures 1 à 6 illustrent les étapes de procédé d'un mode de réalisation de l'invention en vue de la réalisation d'un composant horloger.

### Description détaillée d'un mode de réalisation préféré

La présente invention se rapporte à un procédé de fabrication d'au moins un composant horloger.

La première étape a) consiste à se munir d'un substrat 1, le substrat (1) comprenant des zones métallisées sur l'une de ses faces pour former un masque, et y déposer successivement une couche électriquement conductrice transparente 2, et une couche de résine photosensible 3.

Le substrat 1 utilisé dans l'étape a) du procédé selon l'invention est, par exemple, formé par un substrat en silicium. Lors de la première étape a) du procédé on dépose, par exemple, par un dépôt physique en phase vapeur (PVD), une couche conductrice 2, c'est-à-dire une couche apte à démarrer un dépôt métallique par voie galvanique. Typiquement, la couche conductrice 2 est du type Au, Ti, Pt, Ag, Cr ou Pd (figure 1), ou un empilement d'au moins deux de ces matériaux, et présente une épaisseur comprise entre 50nm et 500nm. Par exemple, la couche conductrice 2 peut être formée d'une sous-couche de chrome ou de titane recouverte d'une couche d'or ou de cuivre.

La résine photosensible 3 utilisée dans ce procédé est de préférence une résine de type négative à base d'époxy octofonctionnelle disponible sous la référence SU-8 conçue pour polymériser sous l'action d'un rayonnement UV.

Selon un mode de réalisation particulier de l'invention, la résine se présente sous la forme d'un film sec, la résine est alors appliquée par laminage sur le substrat 1.

Alternativement, la résine photosensible pourrait être un photorésist positif qui est conçu pour se décomposer sous l'action d'un rayonnement UV. On comprendra que la présente invention ne se limite pas à quelques types particuliers de résine photosensible. L'homme du métier saura choisir une résine photosensible convenant à ses besoins parmi toutes les résines connues qui sont adaptées à la photolithographie par UV.

La couche de résine 3 est déposée sur le substrat 1 par tout moyen approprié, par enduction centrifuge, à la tournette, ou encore par sprayage jusqu'à l'épaisseur souhaitée. Typiquement l'épaisseur de résine est comprise entre 10 µm et 1000 µm, et de préférence entre 50 µm et 300 µm. Selon l'épaisseur désirée et la technique de dépôt utilisée la couche de résine 3 sera déposée en une ou plusieurs fois.

La couche de résine 3 est ensuite chauffée typiquement entre 90 et 120° C pendant une durée dépendant de l'épaisseur déposée pour évacuer le solvant (étape de pre-bake). Ce chauffage sèche et durcit la résine.

L'étape b) suivante illustrée à la figure 2 consiste à effectuer un emboutissage à chaud de la couche de résine 3 pour la mettre en forme et définir un premier niveau du composant horloger. La résine est dans un premier temps chauffée à une température comprise entre 70°C et 150°C où elle devient visqueuse pour permettre sa mise en forme en l'écrasant au moyen d'un tampon 2 venant la presser. Cette étape est réalisée sous vide pour éviter la formation de bulles d'air lors du pressage de la couche de résine 3. Selon l'invention, le tampon 2 peut être pressé jusqu'à une distance prédéfinie du substrat 1 de manière à conserver une couche de résine sur le substrat 1.

Avantageusement, le tampon 2 présente une empreinte en relief pouvant présenter des variations de hauteur et permettant ainsi de définir au moins un premier niveau du composant, ledit au moins premier niveau présente ainsi une géométrie tridimensionnelle complexe qu'il n'est pas possible d'obtenir par un procédé LIGA classique.

Il peut également être envisagé de former deux niveaux ou plus au moyen du tampon.

L' étape c) suivante consiste à irradier par la face arrière du substrat la couche de résine photosensible 3 mise en forme à travers le masque définissant un deuxième niveau du composant à former et ainsi des zones photopolymérisées 3a et des zones non photopolymérisées 3b. U

L'étape illustrée à la figure 3 consistant à irradier la couche de résine 3 au moyen d'un rayonnement UV à travers un masque 4 définissant le deuxième niveau du composant à former et ainsi des zones photopolymérisées 3a et des zones non photopolymérisées 3b est une alternative non-conforme à la présente invention.

Une étape de recuit (étape de post-bake) de la couche de résine 3 peut être nécessaire pour compléter la photopolymérisation induite par l'irradiation UV. Cette étape de recuit est effectuée de préférence entre 90°C et 95°C. Les zones photopolymérisées 3a deviennent insensibles à une grande majorité de solvants. Par contre, les zones non photopolymérisées pourront ultérieurement être dissoutes par un solvant.

Ensuite, on dissout les zones non photopolymérisées 3b de la couche 3 de résine photosensible pour faire apparaître par endroit la couche conductrice 2 du substrat 1 comme sur la figure 4. Cette opération est réalisée par dissolution des zones non photopolymérisées 3b au moyen d'un solvant adéquat, tel que le PGMEA (propylène glycol méthyle éthyle acétate). Un moule en résine photosensible photopolymérisées 3a définissant le premier niveau et le deuxième niveau du composant est ainsi réalisé.

Le substrat 1 est réalisé en un matériau transparent de manière à pouvoir irradier la résine par la face arrière du substrat.

Selon un mode de réalisation préférentiel de l'invention, le substrat est un substrat transparent tel que du verre au borosilicate (Pyrex^{®}) ou tout autre matériau transparent supportant d'être chauffé jusque 150°C. Le substrat comprend une première couche conductrice transparente formée par de l'oxyde d'indium dopé à l'étain (indium tin oxide, ITO) et des motifs métalliques, par exemple réalisé en un alliage de titane et d'or (TiAu) à l'aplomb des zones à ouvrir dans la couche de résine. La couche d'ITO sert à garantir la conductivité électrique de toute la surface, reliant ainsi les motifs métalliques en alliage de titane et d'or à l'aplomb des ouvertures, tout en laissant la lumière passer outre pour polymériser les zones devant l'être.

L'étape d) suivante illustrée à la figure 5 consiste à déposer dans le moule, par électroformage ou dépôt galvanique, une couche 6 -7- d'un métal à partir de la couche électriquement conductrice transparente 2 jusqu'à former un bloc atteignant préférentiellement une hauteur inférieure à la hauteur du moule, cela permettant une meilleure tenue mécanique lors d'un usinage ultérieur. Par métal dans ce contexte sont bien entendu compris les alliages métalliques. Typiquement, le métal sera choisi parmi l'ensemble comprenant le nickel, le cuivre, l'or ou l'argent, et, comme alliage, l'or-cuivre, le nickel-cobalt, le nickel-fer, le nickel-phosphore, ou encore le nickel-tungstène. En général, la structure métallique multicouche est entièrement réalisée dans le même alliage ou métal. Toutefois, il est également possible de changer de métal ou d'alliage au cours de l'étape de déposition galvanique de manière à obtenir une structure métallique comportant au moins deux couches de natures différentes.

Les conditions d'électroformage, notamment la composition des bains, la géométrie du système, les tensions et densités de courant, sont choisies pour chaque métal ou alliage à électrodéposer selon les techniques bien connues dans l'art de l'électroformage.

La couche métallique 6 -7- peut être usinée par un procédé mécanique de manière à obtenir une épaisseur prédéfinie par l'épaisseur du composant à réaliser.

Selon une étape optionnelle se déroulant entre l'étape c) et d), on dépose localement une deuxième couche électriquement conductrice sur certaines zones photopolymérisées 3a mises en forme par l'emboutissage à chaud. Cette deuxième couche électriquement conductrice peut présenter les mêmes caractéristiques que la première couche électriquement conductrice transparente 2.

Selon une première variante, on utilise un masque chablon qui est positionné via un alignement optique. Un tel équipement permet de garantir un bon alignement du masque avec la géométrie des zones photopolymérisées 3a sur le substrat et ainsi garantir un dépôt uniquement sur la surface supérieure des zones photopolymérisées 3a sélectionnées car le masque est maintenu au plus proche du substrat 1.

Selon une autre variante, la deuxième couche électriquement conductrice est mise en oeuvre par une impression 3D pour déposer la deuxième couche électriquement conductrice.

De telles solutions permettent un dépôt sélectif et plus précis de la deuxième couche électriquement conductrice, et donc de mieux maitriser la croissance galvanique lors de l'étape d).

L'étape e), illustrée à la figure 6, consiste à libérer le composant en éliminant par une succession d'étapes de gravure, humide ou sèche, le substrat, les couches conductrices ou les couches de résine, opérations familières à l'homme du métier. Par exemple la première couche électriquement conductrice transparente 2 et le substrat 1 sont éliminés au moyen d'une gravure humide, ce qui permet de libérer le composant du substrat 1 sans l'endommager. Notoirement, le substrat en silicium peut être gravé avec une solution à base d'hydroxyde de potassium (KOH).

A l'issue de cette première séquence, on obtient un composant pris dans la couche de résine, la couche électriquement conductrice transparente 2 étant également encore présente par endroit.

Une deuxième séquence consiste à éliminer la couche de résine 3 au moyen de gravures plasma O₂, espacées de gravures humides des couches métalliques intermédiaires.

A l'issue de cette étape, les composants obtenus peuvent être nettoyés, et éventuellement repris sur une machine-outil pour opérer des usinages ou une terminaison esthétique. A ce stade, les pièces peuvent être directement utilisées ou bien soumises à divers traitements décoratifs et/ou fonctionnels, typiquement des dépôts physiques ou chimiques.

Le procédé de l'invention trouve une application particulièrement avantageuse pour la fabrication de composants pour pièces d'horlogerie, tels que des ressorts, des ancres, des roues, des appliques, etc. Grâce à ce procédé, on peut réaliser des composants de forme plus diverses et présentant des géométries plus complexes que ceux obtenus via des opérations de photolithographie classiques. Un tel procédé permet également d'obtenir des composants robustes et qui présentent une bonne fiabilité au niveau des géométries.

## Revendications

1. Procédé de fabrication d'au moins un composant horloger comprenant les étapes suivantes :
a) se munir d'un substrat (1) transparent, déposer une couche électriquement conductrice transparente (2) sur la face avant du substrat, et y appliquer une couche de résine photosensible (3), le substrat (1) comprenant des zones métallisées sur l'une de ses faces pour former un masque ;
b) effectuer un emboutissage à chaud via un tampon (5) de la couche de résine photosensible (3), en pressant le tampon (5) jusqu'à une distance prédéfinie du substrat (1) de manière à conserver une couche de résine photosensible, pour mettre en forme la couche de résine photosensible (3) et former au moins un premier niveau du composant ;
c) irradier par la face arrière du substrat la couche de résine photosensible (3) mise en forme à travers le masque définissant un deuxième niveau du composant et dissoudre les zones (3b) non irradiées de la couche de résine photosensible (3) pour faire apparaître par endroit la couche électriquement conductrice transparente (2) et former un moule comprenant un premier et un second niveau ;
d) déposer une couche métallique (7) par électroformage dans le moule à partir de la couche électriquement conductrice transparente (2) pour former le composant, la couche métallique (6) atteignant la surface supérieure de la couche de résine photosensible (3) ;
e) éliminer successivement le substrat, la couche électriquement conductrice transparente (2) et la résine photosensible pour libérer le composant.

2. Procédé selon la revendication 1, **caractérisé en ce que** l'étape b) est réalisée sous vide.

3. Procédé selon la revendication 1 ou 2, **caractérisé en ce que** lors de l'étape b), la couche de résine (3) est chauffée entre 70°C et 150°C.

4. Procédé selon l'une des revendications 1 à 3, **caractérisé en ce que** le tampon (5) présente une empreinte en relief, au moins une partie de l'empreinte étant agencée pour être pressée à proximité de la surface du substrat lors de l'étape b).

5. Procédé selon la revendication 4, **caractérisé en ce que** ladite empreinte du tampon (5) définit ledit au moins un premier niveau du composant.

6. Procédé selon l'une des revendications précédentes, **caractérisé en ce qu'**il comprend une étape optionnelle entre l'étape c) et d) qui consiste à déposer localement une deuxième couche électriquement conductrice sur les zones (3a) irradiées de la couche de résine (3).

7. Procédé selon la revendication 6, **caractérisé en ce que** la deuxième couche électriquement conductrice est déposée à travers un masque chablon.

8. Procédé selon la revendication 6, **caractérisé en ce que** la deuxième couche électriquement conductrice est déposée via l'impression d'une encre ou une résine conductrice.

9. Procédé selon l'une des revendications précédentes, **caractérisé en ce que** ladite couche électriquement conductrice transparente (2) est du type Au, Ti, Pt, Ag, Cr, Pd.

10. Procédé selon l'une des revendications précédentes, **caractérisé en ce que** le substrat (1) est en silicium.

11. Procédé selon l'une des revendications précédentes, **caractérisé en ce que** la couche électriquement conductrice transparente (2) présente une épaisseur comprise entre 50nm et 500nm.

## Patentansprüche

1. Verfahren zum Herstellen mindestens eines Uhrenbauteils, das die folgenden Schritte umfasst:
a) Bereitstellen eines transparenten Substrats (1), Abscheiden einer elektrisch leitfähigen, transparenten Schicht (2) auf der Vorderseite des Substrats und Aufbringen einer lichtempfindlichen Harzschicht (3) darauf, wobei das Substrat (1) auf einer seiner Seiten metallisierte Zonen umfasst, um eine Maske zu bilden;
b) Durchführen eines Heißprägens über einem Stempel (5) der lichtempfindlichen Harzschicht (3), indem der Stempel (5) bis zu einem vordefinierten Abstand vom Substrat (1) gedrückt wird, um eine lichtempfindliche Harzschicht beizubehalten, um die lichtempfindliche Harzschicht (3) in Form zu bringen und mindestens einen ersten Bereich des Bauteils zu bilden;
c) Bestrahlen der durch die Maske in Form gebrachten lichtempfindlichen Harzschicht (3) durch die Rückseite des Substrats, wodurch ein zweiter Bereich des Bauteils definiert wird, und Auflösen der nicht bestrahlten Zonen (3b) der lichtempfindlichen Harzschicht (3), um stellenweise die elektrisch leitfähigen, transparente Schicht (2) freizulegen und eine Form zu bilden, die aus einem ersten und einem zweiten Bereich besteht;
d) Aufbringen einer metallischen Schicht (7) durch Elektroformung in der Form, ausgehend von der elektrisch leitfähigen, transparenten Schicht (2), um das Bauteil auszubilden, wobei die metallische Schicht (6) die Oberfläche der lichtempfindlichen Harzschicht (3) erreicht;
e) sukzessives Entfernen des Substrats, der elektrisch leitfähigen, transparenten Schicht (2) und des lichtempfindlichen Harzes, um das Bauteil freizugeben.

2. Verfahren nach Anspruch 1, **dadurch gekennzeichnet, dass** der Schritt b) unter Vakuum durchgeführt wird.

3. Verfahren nach Anspruch 1 oder 2, **dadurch gekennzeichnet, dass** während Schritt b) die Harzschicht (3) zwischen 70 °C und 150°C erhitzt wird.

4. Verfahren nach einem der Ansprüche 1 bis 3, **dadurch gekennzeichnet, dass** der Stempel (5) einen Reliefabdruck aufweist, wobei zumindest ein Teil des Abdrucks so angeordnet ist, dass er während Schritt b) nahe an die Oberfläche des Substrats gedrückt wird.

5. Verfahren nach Anspruch 4, **dadurch gekennzeichnet, dass** der Abdruck des Stempels (5) den mindestens einen ersten Bereich des Bauteils definiert.

6. Verfahren nach einem der vorhergehenden Ansprüche, **dadurch gekennzeichnet, dass** es einen optionalen Schritt zwischen Schritt c) und d) umfasst, der darin besteht, eine zweite elektrisch leitfähige Schicht auf den bestrahlten Zonen (3a) der Harzschicht (3) lokal aufzubringen.

7. Verfahren nach Anspruch 6, **dadurch gekennzeichnet, dass** die zweite elektrisch leitfähige Schicht durch eine Schablonenmaske aufgebracht wird.

8. Verfahren nach Anspruch 6, **dadurch gekennzeichnet, dass** die zweite elektrisch leitfähige Schicht durch das Aufdrucken einer Tinte oder eines leitfähigen Harzes aufgebracht wird.

9. Verfahren nach einem der vorhergehenden Ansprüche, **dadurch gekennzeichnet, dass** die elektrisch leitfähige, transparente Schicht (2) aus Au, Ti, Pt, Ag, Cr, Pd besteht.

10. Verfahren nach einem der vorhergehenden Ansprüche, **dadurch gekennzeichnet, dass** das Substrat (1) aus Silizium besteht.

11. Verfahren nach einem der vorhergehenden Ansprüche, **dadurch gekennzeichnet, dass** die elektrisch leitfähige, transparente Schicht (2) eine Dicke zwischen 50 nm und 500 nm aufweist.

## Claims

1. Method for manufacturing at least one timepiece component comprising the following steps of:
a) providing a transparent substrate (1), depositing a transparent, electrically conductive layer (2) on the front face of the substrate, and applying a photoresist layer (3) thereon, the substrate (1) comprising metallised areas on one of its faces to form a mask;
b) hot-pressing the photoresist layer (3) using a stamp (5), by pressing the stamp (5) up to a predefined distance from the substrate (1) so as to retain a photoresist layer, in order to shape the photoresist layer (3) and form at least a first level of the component;
c) irradiating, from the rear face of the substrate, the shaped photoresist layer (3) through the mask defining a second level of the component, and dissolving the non-irradiated areas (3b) of the photoresist layer (3) to expose the transparent, electrically conductive layer (2) in places and to form a mould comprising a first and a second level;
d) depositing a metal layer (7) by electroforming in the mould from the transparent, electrically conductive layer (2) to form the component, the metal layer (6) substantially reaching the top surface of the photoresist layer (3);
e) successively removing the substrate, the transparent, electrically conductive layer (2) and the photoresist to release the component.

2. Method according to claim 1, **characterised in that** step b) is carried out in a vacuum.

3. Method according to claim 1 or 2, **characterised in that** in step b), the photoresist layer (3) is heated to between 70°C and 150°C.

4. Method according to one of claims 1 to 3, **characterised in that** the stamp (5) has a raised impression, at least part of the impression being arranged to be pressed close to the surface of the substrate during step b).

5. Method according to claim 4, **characterised in that** said impression of the stamp (5) defines said at least one first level of the component.

6. Method according to one of the preceding claims, **characterised in that** it comprises an optional step between step c) and d) which consists of locally depositing a second electrically conductive layer on the irradiated areas (3a) of the photoresist layer (3).

7. Method according to claim 6, **characterised in that** the second electrically conductive layer is deposited through a stencil mask.

8. Method according to claim 6, **characterised in that** the second electrically conductive layer is deposited by printing an ink or a conductive resin.

9. Method according to one of the preceding claims, **characterised in that** said transparent, electrically conductive layer (2) is of the Au, Ti, Pt, Ag, Cr, or Pd type.

10. Method according to one of the preceding claims, **characterised in that** the substrate (1) is made of silicon.

11. Method according to one of the preceding claims, **characterised in that** the transparent, electrically conductive layer (2) has a thickness of between 50 nm and 500 nm.
